(19) Europäisches Patentamt / European Patent Office / Office européen des brevets

(11) **EP 3 086 131 B1**

(12) **FASCICULE DE BREVET EUROPEEN**

(45) Date de publication et mention de la délivrance du brevet:
**10.03.2021 Bulletin 2021/10**

(51) Int Cl.:
*G01R 19/32* $^{(2006.01)}$  *G01R 19/165* $^{(2006.01)}$
*H02H 3/08* $^{(2006.01)}$  *H02H 7/122* $^{(2006.01)}$

(21) Numéro de dépôt: **16164239.2**

(22) Date de dépôt: **07.04.2016**

(54) **DISPOSITIF DE MESURE D'UN COURANT DANS UN CIRCUIT ELECTRIQUE**

STROMMESSVORRICHTUNG IN EINEM ELEKTRISCHEN SCHALTKREIS

DEVICE FOR MEASURING A CURRENT IN AN ELECTRIC CIRCUIT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.04.2015 FR 1500742**

(43) Date de publication de la demande:
**26.10.2016 Bulletin 2016/43**

(73) Titulaire: **NEXTER Systems**
**42300 Roanne (FR)**

(72) Inventeurs:
• **DECROUX, Philippe**
  **18023 BOURGES (FR)**
• **CASTAING, Michel**
  **18023 BOURGES (FR)**
• **DEGOUTTE, Cédric**
  **18023 BOURGES (FR)**

(74) Mandataire: **Cabinet Chaillot**
**16/20, avenue de l'Agent Sarre**
**B.P. 74**
**92703 Colombes Cedex (FR)**

(56) Documents cités:
**JP-A- 2012 154 829    US-A1- 2006 255 858**
**US-A1- 2011 089 931**

**Description**

Le domaine technique de l'invention est celui des dispositifs de mesure de courant dans un circuit électrique.

Il est classique de réaliser une mesure de courant en utilisant un shunt ou un capteur inductif.

Cependant ces solutions occupent un volume trop important, en particulier lorsque le circuit est parcouru par une forte intensité (de l'ordre de quelques centaines d'ampères).

Il a déjà été proposé de mesurer la chute de tension aux bornes de transistors (par exemple les transistors MOSFET couramment appelés transistors MOS) du circuit. En effet les circuits dans lesquels circule une forte intensité comportent la plupart du temps au niveau de leurs contacteurs des composants interrupteurs de puissance de type MOS.

Cette solution présente cependant comme inconvénient que les transistors (en particuliers les MOS) ont une résistance qui est dépendante de la température.

Il en résulte une erreur sur la mesure de l'intensité.

On connaît par le brevet FR2656932 un circuit de mesure du courant dans lequel la mesure est réalisée par l'intermédiaire d'autres transistors de même technologie mais de plus petite taille. Le fait d'utiliser les même technologies permet en principe (et avec un circuit adapté) de s'affranchir des variations de températures, les transistors de mesure ayant une résistance qui varie de la même manière que celle du transistor MOS au niveau duquel on mesure la chute de tension.

Ce montage présente cependant l'inconvénient de nécessiter la mise en place d'autres transistors MOS dont l'encombrement n'est pas négligeable.

Par ailleurs il n'est pas certain dans un montage donné que la température soit la même dans tous les transistors, ce qui conduit à des erreurs de mesure. Le brevet estime l'erreur de mesure observée de l'ordre de 5% ce qui reste encore trop élevé.

Il a également été proposé par le brevet EP0744033 de mesurer une intensité dans un circuit mais en mettant en œuvre un montage de mesure spécifique comportant une résistance de mesure qui est distincte de celle des transistors MOS de puissance. Une telle solution est également encombrante.

Ce brevet propose de réaliser une compensation des variations de température de la résistance de mesure à l'aide d'un montage de différents transistors ayant des zones d'émetteur différentes ou des nombres différents de régions d'émetteur. Ce montage est également encombrant et complexe.

La demande de brevet américain US2011/089931 décrit un dispositif de mesure de courant électrique dans un circuit, dans lequel la mesure du courant est effectuée aux bornes d'un composant résistif du circuit, la mesure étant mise en œuvre par un amplificateur opérationnel associé à une résistance dont le gain varie en fonction de la température. Dans cette solution, les résistances modifiant le gain varient parce-qu'elles sont en contact thermique avec le composant résistif. Une telle solution peut convenir lorsque l'influence de la température reste faible. L'utilisation de résistances variables en fonction de la température pour compenser les variations de résistance du composant résistif induit une erreur de compensation, par exemple de +/- 8% pour un composant résistif de type MOS, qui est trop importante.

C'est le but de l'invention que de proposer un dispositif de mesure de courant dans un circuit électrique qui ne présente pas de tels inconvénients. Le dispositif selon l'invention est d'encombrement réduit. Il permet de mesurer l'intensité circulant dans les composants de puissance sans perturbations dues aux variations de température du composant.

En particulier le dispositif selon l'invention permet de déterminer un seuil d'intensité avec une erreur très faible et pour une plage de température large.

A titre d'exemple le dispositif selon l'invention permet d'obtenir une erreur sur la détermination du seuil inférieure à 3% pour une plage de température de -50°C à +100°C.

Le dispositif selon l'invention peut être mis en œuvre pour tout type de circuit incorporant un composant électronique, électrique ou électromécanique ayant une loi de variation de la résistance en fonction de la température qui est connue et modélisable, et en particulier une loi monotone (croissante ou décroissante).

Ainsi l'invention a pour objet un dispositif de mesure de courant dans un circuit électrique, dispositif dans lequel la mesure d'un courant I est effectuée aux bornes d'un composant incorporé en série dans le circuit, mesure réalisée en mettant en œuvre au moins un amplificateur opérationnel alimenté par le courant circulant dans le composant, dispositif caractérisé en ce qu'il comporte un calculateur couplé à un capteur de mesure de la température du composant et à une résistance variable $R_V$ incorporée dans le circuit de réglage du gain de l'amplificateur opérationnel, le calculateur étant doté d'un algorithme pilotant la valeur de la résistance variable $R_V$ en fonction de la résistance interne $R_{ON}$ du composant qui varie elle-même en fonction de la température suivant une loi ou une table incorporée dans le calculateur, de telle sorte que, si on note $V_S$ la tension de sortie de l'amplificateur opérationnel qui est image du courant I à mesurer, la résistance variable $R_V$ est corrigée de façon à ce que le rapport $K=V_S/I$ soit constant sur toute la plage de températures d'utilisation du circuit.

Ainsi l'invention, contrairement à la divulgation de la demande de brevet américain US2011/089931, permet de compenser des variations de températures de grande amplitude et qui ne sont pas linéaires, par la présence d'un calculateur qui permet un pilotage de résistances variables numériques, absent dans la demande de brevet américain US2011/089931.

Selon un mode particulier de réalisation, la résistance variable $R_V$ pourra être disposée en série avec une première résistance fixe R1 du montage de l'amplificateur opérationnel, la résistance de contre-réaction étant notée R2, la résistance du composant étant notée $R_{ON}$, K étant le rapport constant $V_S/I$, la résistance variable $R_V$ aura une valeur :

$$R_V = (R1 + R2 - K.R1/R_{ON}).[R_{ON}/(K-R_{ON})]$$

Selon un mode particulier de réalisation, la tension de sortie $V_S$ analogique de l'amplificateur opérationnel pourra être convertie en une valeur numérique $V_\mu$ par le calculateur auquel la tension $V_S$ sera appliquée par l'intermédiaire d'un pont diviseur formé de deux résistances R3 et R4, la tension $V_\mu$ numérique convertie par le calculateur étant ainsi égale à :

$$V_\mu = V_S.[R4/(R4+R3)].[2^n/V_{ref}]$$

Vref étant la tension de référence du convertisseur analogique / numérique incorporé au calculateur et n étant la résolution de ce convertisseur.

Avantageusement, la valeur de la résistance variable $R_V$ pourra être corrigée par un coefficient correcteur de pente P, coefficient qui est calculé au cours d'un étalonnage préalable à l'utilisation du dispositif et qui sera appliqué au rapport K (rapport corrigé K' = P.K), le coefficient P étant calculé en mesurant le rapport entre les écarts attendus et effectifs entre deux mesures successives de la tension $V_\mu$ image numérique de l'intensité mesurée vue par le calculateur.

Avantageusement, la valeur mesurée pourra également être corrigée d'une valeur d'offset B qui sera calculée lors d'un étalonnage préalable et qui sera multipliée lors de la mesure par le gain Gm du dispositif au moment de la mesure, soit $V_{\mu cor}$ = $V_\mu$ - B.Gm expression dans laquelle $V_{\mu cor}$ est la valeur de la mesure telle que corrigée et utilisée pour le pilotage de $R_V$, $V_\mu$ est la valeur de l'image numérique de l'intensité en sortie du convertisseur analogique / numérique, et $G_m$ le gain du dispositif au moment de la mesure considérée ($G_m$ = 1 + R2/(R1+$R_V$)), la valeur d'offset B étant une valeur corrigée lors de l'étalonnage et correspondant à un offset b calculé entre deux mesures successives et divisé par le gain $G_e$ du dispositif au moment de l'étalonnage (B = b/$G_e$).

Selon un mode particulier de mise en œuvre, la tension de sortie $V_S$ de l'amplificateur opérationnel pourra être appliquée à un circuit comparateur pouvant provoquer l'ouverture du circuit dans lequel le courant I circule lorsque la tension $V_S$ dépasse un seuil $V_L$.

L'invention sera mieux comprise à la lecture de la description qui va suivre de modes particuliers de réalisation, description faite en référence aux dessins annexés et dans lesquels :

- La figure 1 est un schéma simplifié d'un dispositif de mesure selon l'invention ;
- La figure 2 est une courbe montrant l'erreur de détermination d'une intensité ou d'un seuil de courant avec ou sans le dispositif selon l'invention.

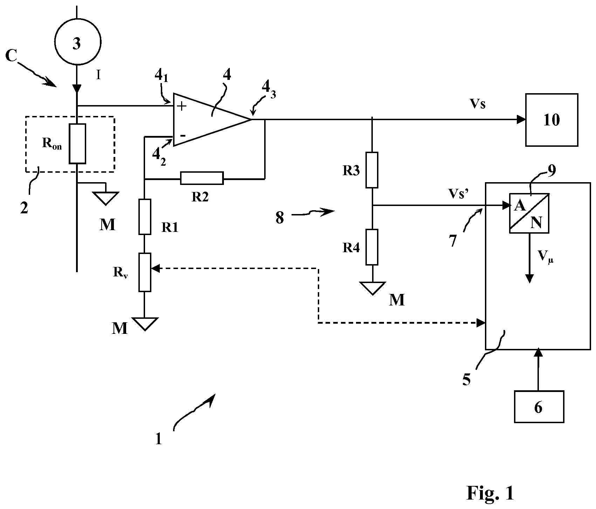

En se reportant à la figure 1, un dispositif de mesure 1 du courant circulant dans un circuit électrique C, réalise la mesure du courant I qui circule dans un composant 2 (ici un transistor MOSFET, plus communément désigné transistor MOS) de ce circuit C. Un tel transistor 2 est par exemple un contacteur statique à semi-conducteur d'un circuit alimentant une charge 3. Le point M est la masse ou pôle commun des circuits.

Ces transistors MOS sont utilisés en particulier dans les contrôleurs de puissance à semi-conducteurs, aussi appelés SSPC (acronyme de leur dénomination anglaise Solid State Power Controller). Ces contrôleurs ont pour but d'alimenter une charge 3 en un courant ayant des caractéristiques de tension et de puissance données. Ces dispositifs permettent de commander l'ouverture de circuits fonctionnant avec des tensions importantes (de 12 volts à 1000 volts) et avec des intensités de quelques centaines d'ampères pendant la phase de fermeture ou d'ouverture.

On a représenté sur la figure 1 la résistance interne $R_{ON}$ du transistor 2 qui est parcourue par le courant I.

Le dispositif selon l'invention réalise la mesure en mettant en œuvre au moins un amplificateur opérationnel 4 qui est alimenté par le courant I circulant dans le transistor MOS 2. Ce courant est appliqué à une entrée non inverseuse $4_1$ de l'amplificateur 4. L'autre entrée $4_2$ (inverseuse) de l'amplificateur 4 est reliée à la masse M du circuit par une première résistance R1 qui est montée en série avec une résistance variable $R_V$ qui est une résistance variable numérique.

Une résistance de contre-réaction R2 est montée entre l'entrée $4_2$ de l'amplificateur et sa sortie $4_3$.

Le dispositif 1 comporte un calculateur 5, par exemple un microprocesseur, qui est couplé à un capteur 6 de mesure de la température du transistor MOS 2.

Le calculateur 5 est relié à la résistance variable numérique $R_V$ dont il peut commander les modifications de la valeur.

Le signal de sortie $V_S$ de l'amplificateur 4 est une image du courant I circulant dans le transistor MOS 2.

Ce signal $V_S$ est égal à : $Vs = \left[1 + \frac{R2}{R1+Rv}\right] Ron.I$ expression dans laquelle le gain de l'amplificateur G est égal à $1 + \frac{R2}{R1+Rv}$ .

La résistance variable $R_V$ est donc incorporée dans le circuit de réglage du gain G de l'amplificateur opérationnel 4. Une modification de cette résistance $R_V$ permettra de modifier le gain de l'amplificateur 4.

Conformément à l'invention, le calculateur 5 est doté d'un algorithme qui permet de piloter la valeur de la résistance variable $R_V$ en fonction de la résistance interne $R_{ON}$ du transistor.

Cette résistance $R_{ON}$ varie en fonction de la température du transistor 2. Ces variations de $R_{ON}$ en fonction de la température sont connues car elles font partie des caractéristiques techniques du transistor 2 et sont données par le fournisseur.

Elles peuvent être incorporées dans le calculateur 5 sous la forme d'une modélisation, par exemple une modélisation polynomiale telle que $R_{ON} = at^2 + bt + c$ (expression dans laquelle t est la température du composant).

Elles peuvent aussi être incorporées au calculateur 5 sous la forme d'une table de valeurs $(t_i, R_{ON}i)$ qui est mise en mémoire dans le calculateur 5.

Ainsi le calculateur 5 peut associer à toute valeur de la température t qui est mesurée par le capteur 6 une valeur de la résistance $R_{ON}$ du transistor 2.

Le capteur 6 sera positionné au plus près du transistor 2 pour donner une mesure de la température la plus exacte possible. On pourra utiliser comme capteur 6 un composant du type : thermomètre à résistance de platine (sonde PT100), thermistance à coefficient de température négatif (CTN), capteur sur liaison série (bus série SPI ou « Synchronous Peripheral Interface »)...

Le calculateur 5 peut ainsi piloter la valeur de la résistance variable $R_V$ en fonction de la température de la résistance interne $R_{ON}$ du transistor.

Suivant une autre caractéristique de l'invention, l'algorithme de pilotage de la résistance variable $R_V$ est tel que le rapport $K = V_S/I$ soit constant sur toute la plage de températures d'utilisation du circuit.

On a noté que $\frac{Vs}{I.Ron} = \left[1 + \frac{R2}{R1+Rv}\right] = G.$

Ecrire que le rapport $K = V_S/I$ est constant revient à écrire que le produit $K = G.R_{ON}$ est également constant.

Selon l'invention l'introduction de la résistance variable numérique $R_V$ permet de modifier le gain G de l'amplificateur 4 et le pilotage par le calculateur 5 est assuré de telle sorte que le produit de ce gain G par la résistance $R_{ON}$ du transistor reste constant sur la plage de température d'utilisation souhaitée.

Ainsi lorsque la résistance $R_{ON}$ du transistor 2 est minimale (pour la température minimale), le gain G sera modifié pour avoir sa valeur maximale.

Inversement lorsque la résistance $R_{ON}$ du transistor 2 est maximale (pour la température maximale), le gain G sera modifié pour avoir sa valeur minimale.

La valeur à donner à la résistance $R_V$ se calcule de la façon suivante :

$$\frac{Vs}{I.Ron} = \left[1 + \frac{R2}{R1+Rv}\right] = G \rightarrow Rv = \frac{1}{\frac{Vs}{I.Ron} - 1}\left(R1 + R2 - \frac{Vs}{I.Ron}R1\right)$$

Ce qui peut s'écrire sous la forme :

$$R_V = (R1 + R2 - K.R1/R_{ON}).[R_{ON}/(K-R_{ON})]$$

En posant $K = V_S/I$

Le rapport K étant fixé en fonction du seuil de déclenchement souhaité, la connaissance de la valeur de $R_{ON}$ grâce au capteur 6 permet au calculateur 5 de déterminer à tout moment la valeur à donner à la résistance numérique variable $R_V$.

Le choix des résistances R1 et R2 du circuit sera fait en fonction de la plage de température d'utilisation envisagée et en fonction de la valeur du rapport K qui sera fixée.

La valeur de K sera fixée d'une façon préférée à la valeur du rapport $V_S/I$ correspondant à l'intensité I à laquelle il est nécessaire d'ouvrir le contacteur pour protéger le circuit. La tension Vs correspond alors au seuil de déclenchement d'un circuit 10 qui sera un comparateur de tension à référence interne fixée. Ce circuit est décrit par la suite.

Pour tenir compte des dispersions possibles sur la valeur de la résistance $R_{ON}$ du transistor 2 (ainsi que des dérives en température), on pourra dimensionner le dispositif 1 de telle sorte que les valeurs maximales et minimales théoriques pour $R_{ON}$ soient :

$$\text{RM} = R_{ON}(\text{Tmax}) + 10\% \text{ et Rm} = R_{ON}(\text{Tmin}) - 10\%.$$

On notera alors Ra la valeur maximale de $R_V$ et Ri la valeur minimale de $R_V$.

On pourra alors écrire les relations suivantes :

$$\frac{K}{RM} = 1 + \frac{R2}{R1 + Ra} \qquad \frac{K}{Rm} = 1 + \frac{R2}{R1 + Ri}$$

Ce qui permettra de déterminer les valeurs de R1 et de R2 :

$$R2 = \left(\frac{K}{RM} - 1\right)(R1 + Ra) \text{ avec } R1 = \frac{\left(1 - \frac{K}{Rm}\right)Ri + \left(\frac{K}{RM} - 1\right)Ra}{\frac{K}{Rm} - \frac{K}{RM}}$$

La tension $V_S$ est une image du courant I. Elle est appliquée à un circuit 10 qui pourra être un circuit évaluateur qui donnera après conversion et mise à l'échelle une valeur en Ampère du courant I.

Le circuit 10 pourra être un comparateur qui comparera la valeur $V_S$ à une valeur limite $V_L$. Ce comparateur provoquera l'ouverture du circuit dans lequel le courant I circule lorsque l'intensité I dépasse un niveau $I_L$ donné et auquel correspond une valeur $V_S = V_L$.

Les fonctions du circuit 10 pourront aussi être assurées par le calculateur 5 lui-même.

La résistance variable numérique $R_V$ est pilotée par le calculateur 5. Ce dernier ne peut être attaqué directement par le signal de sortie $V_S$ de l'amplificateur 4. Ainsi, dans le cas où la tension de sortie $V_S$ est supérieure à la valeur maximale pouvant être traitée par le convertisseur analogique /numérique 9 du calculateur 5, une partie $V_V$' seulement du signal de sortie $V_S$ est appliquée à une entrée 7 du calculateur 5.

Pour cela la tension de sortie $V_S$ analogique de l'amplificateur opérationnel 4 est appliquée au calculateur 5 par l'intermédiaire d'un pont diviseur 8 formé de deux résistances R3 et R4.

Le calculateur 5 incorpore de façon classique un convertisseur analogique / numérique 9 qui a une tension de référence (ou plage de conversion) notée Vref et une résolution notée n.

La tension $V\mu$ numérique qui est issue de la conversion faite par le calculateur 5 est ainsi égale à :

$$V\mu = V_S.[R4/(R4+R3)].[2^n/V_{ref}]$$

Concrètement, avec un convertisseur de résolution 8 bits (n=8), la loi de commande de la valeur de Rv sera du type : $Rv = \frac{x}{256}Ra + Ri$ expression dans laquelle Ra est la valeur maximale de $R_V$ et Ri la valeur minimale de $R_V$.

La mise en œuvre du dispositif de mesure selon l'invention conduit à une minimisation de l'erreur de mesure, et en particulier de l'erreur de détermination d'un seuil de courant.

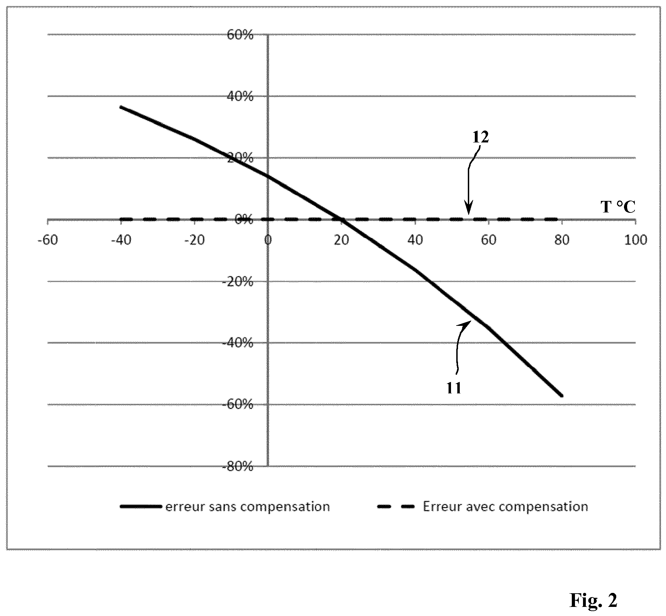

La figure 2 montre ainsi le pourcentage d'erreur sur la mesure (ou la détermination de seuil) pour une plage d'emploi allant d'une température de -40°C à +80°C.

Lorsque le dispositif selon l'invention n'est pas mis en œuvre on remarque (courbe 11) que l'erreur de mesure varie de +40% à -60%.

Grâce à l'invention et sur toute la plage d'emploi, l'erreur (courbe 12) reste inférieure à 1%.

A titre comparatif, on notera que, si un calculateur 5 est mis en œuvre avec un ampli opérationnel 4 monté avec un gain fixe (résistances R1 et R2 mais pas de résistance variable $R_V$), une plage de variation de températures allant de -50°C à +100°C conduit à une variation de la résistance $R_{ON}$ du transistor 2 qui varie de 1,8 mΩ (pour -50°C) à 3,5mΩ (pour +100°C). Le convertisseur analogique/digital 9 du calculateur devrait donc supporter pour un même courant d'entrée I une variation du simple au double de la tension à convertir. De telles performances ne sont pas possibles avec les convertisseurs standard. De plus avec cette solution un seuil d'intensité devant conduire à une ouverture du transistor ne pourrait être déterminé, le seuil dépendrait en effet de la température du composant $R_{ON}$.

Afin de tenir compte des imperfections de l'amplificateur 4 (tension d'offset) ainsi que de la dérive de la résistance $R_{ON}$, on procédera avant toute utilisation du dispositif 1 à un étalonnage.

L'étalonnage pourra comporter deux étapes : la correction de la pente (dérive de la résistance $R_{ON}$) et la correction de l'Offset de l'amplificateur 4.

Pour corriger la pente on corrigera au niveau du calculateur 5 la valeur de la résistance variable $R_V$ en appliquant à l'algorithme un coefficient correcteur de pente P.

Ce coefficient est calculé au cours d'un étalonnage préalable à l'utilisation du dispositif.

Pour cela on mesure dans un premiers temps pour deux valeurs différentes de l'intensité I (I1 et I2) donc pour deux valeurs différentes attendues de la tension : $V_{S1}$ et $V_{S2}$, les valeurs réelles mesurées par le calculateur $V_{\mu1}$ et $V_{\mu2}$. La valeur de la pente P est égale à

$$P = (V_{S2} - V_{S1}) / (V_{\mu2} - V_{\mu1})$$

Les valeurs $V_{S1}$ et $V_{S2}$ sont des valeurs connues et fixées qui sont associées au courant par une loi de proportionnalité simple. Les valeurs I1 et I2 doivent être situées aux extrémités de la plage de mesure.

La valeur de la pente P (valeur de P égale à 1 avant étalonnage) est mise en mémoire dans le calculateur 5. Elle est appliquée au rapport K (rapport corrigé K' = P.K). L'expression de $R_V$ s'écrit alors :

$$R_V = (R1 + R2 - K'.R1/R_{ON}) . [R_{ON}/(K'-R_{ON})]$$

soit :

$$R_V = (R1 + R2 - PK.R1/R_{ON}) . [R_{ON}/(PK-R_{ON})]$$

La correction de l'Offset de l'amplificateur 4 est également mesurée au cours de l'étalonnage. D'une façon classique, l'Offset provoque un décalage linéaire des signaux et il est donc nécessaire de soustraire la valeur de l'Offset de la valeur $V_S$ mesurée.

La tension numérique calculée a donc la forme :

$V_{\mu2} = a V_{S2} + b$, expression linéaire dans laquelle a est le coefficient directeur de la droite, c'est à dire correspond à l'inverse de la pente P précédemment calculée

$a = 1/P$.

b se calcule donc par : $b = V_{\mu2} - a V_{S2}$

Conformément à l'invention il est cependant nécessaire de corriger la valeur d'Offset b ainsi calculée pour tenir compte de la variation du gain en fonction de la valeur de $R_V$.

On déterminera donc lors de l'étalonnage la valeur b et le calculateur calculera une valeur B = b/$G_e$ qui est la valeur d'offset correspondant à la mesure d'étalonnage mais divisée par le Gain Ge du dispositif au moment de l'étalonnage ; $G_e$ = 1 + R2/(R1+$R_{Ve}$) ; $R_{Ve}$ étant la valeur de $R_V$ calculée au moment de l'étalonnage.

Par la suite, et pour tenir compte des variations du gain en fonction de la température, le calculateur déterminera à tout moment une valeur numérique corrigée $V_{\mu cor}$ qui sera égale à $V_{\mu cor}$ = $V_\mu$ - B.G, expression dans laquelle $V_{\mu cor}$ est la valeur de la mesure telle que corrigée et utilisée pour le pilotage de $R_V$, $V_\mu$ est la valeur de l'image numérique de l'intensité en sortie du convertisseur analogique / numérique 9, et G le gain du dispositif au moment de la mesure , c'est à dire : G = 1 + R2/ (R1+$R_V$) avec la valeur de $R_V$ calculée au moment de la mesure.

D'une autre façon on peut ainsi écrire :

$$V_{\mu cor} = V_\mu - b . (G/G_e)$$

Diverses variantes sont possibles sans sortir du cadre de l'invention.

La description a été faite en référence à un circuit incorporant un composant 2 qui est un transistor de type MOSFET, dont la loi de variation de la résistance en fonction de la température est monotone (croissante ou décroissante).

L'invention peut aussi être mise en œuvre en mesurant le courant dans un autre type de composant dont la résistance varie en fonction de la température d'une façon connue et modélisée et qui n'est pas forcément monotone. Par exemple un composant de type transistor MOS au Carbure de Silicium (dont la résistance varie en fonction de la température de façon non monotone).

L'essentiel est que le calculateur incorpore une loi ou table modélisant la variation de la résistance interne $R_{ON}$ du composant en fonction de la température et qui pilote la résistance variable $R_V$ en fonction de cette variation.

L'invention pourrait aussi être mise en œuvre avec un autre composant qu'un transistor de puissance et ayant une résistance interne variable en fonction de la température, par exemple un relais ou un contacteur ou encore un câble d'interconnexion dont la longueur serait suffisante pour que sa résistance permette de mesure une chute de tension à ses bornes.

**Revendications**

1.  Dispositif (1) de mesure de courant dans un circuit électrique (C), dispositif dans lequel la mesure d'un courant I est effectuée aux bornes d'un composant (2) incorporé en série dans le circuit, mesure réalisée en mettant en œuvre au moins un amplificateur opérationnel (4) alimenté par le courant circulant dans le composant (2), dispositif *caractérisé en ce qu'*il comporte un calculateur (5) couplé à un capteur (6) de mesure de la température du composant (2) et à une résistance variable $R_V$ incorporée dans le circuit de réglage du gain de l'amplificateur opérationnel (4), le calculateur (5) étant doté d'un algorithme pilotant la valeur de la résistance variable $R_V$ en fonction de la résistance interne $R_{ON}$ du composant (2) qui varie elle-même en fonction de la température suivant une loi ou une table incorporée dans le calculateur (5), de telle sorte que, si on note $V_S$ la tension de sortie de l'amplificateur opérationnel (4) qui est image du courant I à mesurer, la résistance variable $R_V$ est corrigée de façon à ce que le rapport $K=V_S/I$ soit constant sur toute la plage de températures d'utilisation du circuit.

2.  Dispositif de mesure de courant selon la revendication 1, **caractérisé en ce que** la résistance variable $R_V$ est disposée en série avec une première résistance fixe R1 du montage de l'amplificateur opérationnel (4), la résistance de contre-réaction étant notée R2, la résistance du composant étant notée $R_{ON}$, K étant le rapport constant $V_S/I$, la résistance variable $R_V$ aura une valeur :

$$R_V = (R1 + R2 - K.R1/R_{ON}).[R_{ON}/(K-R_{ON})]$$

3.  Dispositif de mesure de courant selon la revendication 2, **caractérisé en ce que** la tension de sortie $V_S$ analogique de l'amplificateur opérationnel (4) est convertie en une valeur numérique $V_\mu$ par le calculateur (5) auquel la tension $V_S$ est appliquée par l'intermédiaire d'un pont diviseur formé de deux résistances R3 et R4, la tension $V_\mu$ numérique convertie par le calculateur étant ainsi égale à :

$$V_\mu = V_S.[R4/(R4+R3)].[2^n/V_{ref}]$$

    Vref étant la tension de référence du convertisseur analogique / numérique (9) incorporé au calculateur (5) et n étant la résolution de ce convertisseur (9).

4.  Dispositif de mesure de courant selon la revendication 3, **caractérisé en ce que** la valeur de la résistance variable $R_V$ est corrigée par un coefficient correcteur de pente P, coefficient qui est calculé au cours d'un étalonnage préalable à l'utilisation du dispositif et qui est appliqué au rapport K (rapport corrigé K' = P.K), le coefficient P étant calculé en mesurant le rapport entre les écarts attendus et effectifs entre deux mesures successives de la tension $V_\mu$ image numérique de l'intensité mesurée vue par le calculateur (5).

5.  Dispositif de mesure de courant selon la revendication 4, **caractérisé en ce que** la valeur mesurée est corrigée d'une valeur d'offset B qui est calculée lors d'un étalonnage préalable et qui est multipliée lors de la mesure par le gain Gm du dispositif au moment de la mesure, soit $V_{\mu cor} = V_\mu - B.Gm$ expression dans laquelle $V_{\mu cor}$ est la valeur de la mesure telle que corrigée et utilisée pour le pilotage de $R_V$, $V_\mu$ est la valeur de l'image numérique de l'intensité en sortie du convertisseur analogique / numérique (9), et $G_m$ le gain du dispositif au moment de la mesure considérée ($G_m = 1 + R2/(R1+R_V)$), la valeur d'offset B étant une valeur corrigée lors de l'étalonnage et correspondant à un offset b calculé entre deux mesures successives et divisé par le gain $G_e$ du dispositif au moment de l'étalonnage ($B = b/G_e$).

6. Dispositif de mesure de courant selon une des revendications 1 à 5, **caractérisé en ce que** la tension de sortie $V_S$ de l'amplificateur opérationnel (4) est appliquée à un circuit comparateur (10) pouvant provoquer l'ouverture du circuit dans lequel le courant I circule lorsque la tension $V_S$ dépasse un seuil $V_L$.

**Patentansprüche**

1. Strommessvorrichtung (1) in einem elektrischen Schaltkreis (C), wobei bei der Vorrichtung das Messen eines Stroms I an den Klemmen eines Bauteils (2) durchgeführt wird, das in Reihe in den Schaltkreis integriert ist, wobei die Messung durchgeführt wird, indem mindestens ein operativer Verstärker (4) eingesetzt wird, der von dem Strom versorgt wird, der in dem Bauteil (2) fließt, wobei die Vorrichtung **dadurch gekennzeichnet ist, dass** sie einen Rechner (5) aufweist, der an einen Sensor (6) zum Messen der Temperatur des Bauteils (2) und an einen variablen Widerstand $R_V$ gekoppelt ist, der in den Schaltkreis zur Regelung der Verstärkung des operativen Verstärkers (4) integriert ist, wobei der Rechner (5) mit einem Algorithmus versehen ist, der den Wert des variablen Widerstands $R_V$ in Abhängigkeit vom inneren Widerstand $R_{ON}$ des Bauteils (2) steuert, der selbst in Abhängigkeit von der Temperatur gemäß einem in den Rechner (5) integrierten Gesetz oder einer Tabelle schwankt, so dass, wenn $V_S$ die Ausgangsspannung des operativen Verstärkers (4) ist, die das Abbild des zu messenden Stroms I ist, der variable Widerstand $R_V$ derart korrigiert wird, dass das Verhältnis $K=V_S/I$ über den gesamten Nutzungs-Temperaturbereich des Schaltkreises konstant ist.

2. Strommessvorrichtung nach Anspruch 1, **dadurch gekennzeichnet, dass** der variable Widerstand $R_V$ in Reihe mit einem ersten festen Widerstand R1 der Montage des operativen Verstärkers (4) angeordnet ist, wobei der Gegenreaktions-Widerstand R2 ist, wobei der Widerstand des Bauteils $R_{ON}$ ist, wobei K das konstante Verhältnis $V_S/I$ ist, wobei der variable Widerstand $R_V$ einen Wert $R_V = (R1 + R2 - K.R1/R_{ON}) . [R_{ON}/(K-R_{ON})]$ hat.

3. Strommessvorrichtung nach Anspruch 2, **dadurch gekennzeichnet, dass** die analoge Ausgangsspannung $V_S$ des operativen Verstärkers (4) in einen digitalen Wert $V_\mu$ von dem Rechner (5) umgewandelt wird, auf den die Spannung $V_S$ über eine Teilerbrücke angewendet wird, die von zwei Widerständen R3 und R4 gebildet ist, wobei die von dem Rechner umgewandelte digitale Spannung $V_\mu$ somit gleich $V_\mu = V_S \cdot [R4/(R4+R3)] [2^n/V^{ref}]$ ist, wobei Vref die Referenzspannung des Analog-Digital-Wandlers (9) ist, der in den Rechner (5) integriert ist n die Auflösung dieses Wandlers (9) ist.

4. Strommessvorrichtung nach Anspruch 3, **dadurch gekennzeichnet, dass** der Wert des variablen Widerstands $R_V$ durch einen Steigungskorrekturkoeffizienten P korrigiert wird, wobei der Koeffizient während einer der Verwendung der Vorrichtung vorherigen Eichung berechnet wird und der auf das Verhältnis K angewendet wird (korrigiertes Verhältnis K' = P.K), wobei der Koeffizient P durch Messen des Verhältnisses zwischen den erwarteten und tatsächlichen Abweichungen zwischen zwei aufeinanderfolgenden Messungen der Spannung $V_\mu$ als digitales Abbild der gemessenen, vom Rechner (5) festgestellten Stromstärke berechnet wird.

5. Strommessvorrichtung nach Anspruch 4, **dadurch gekennzeichnet, dass** der gemessene Wert um einen Offsetwert B korrigiert wird, der bei einer vorherigen Eichung berechnet wird und der bei der Messung mit der Verstärkung Gm der Vorrichtung im Augenblick der Messung multipliziert wird, d. h. $Y_{\mu cor} = V_\mu - B.Gm$, wobei bei diesem Ausdruck $Y_{\mu cor}$ der Wert der Messung wie korrigiert und für die Steuerung von $R_V$ verwendet ist, $V_\mu$ der Wert des digitalen Abbilds der Stärke am Ausgang des Analog-Digital-Wandlers (9) und $G_m$ die Verstärkung der Vorrichtung im Augenblick der entsprechenden Messung ($G_m = 1 + R2/(R1+R_V)$) ist, wobei der Offsetwert B ein bei der Eichung korrigierter Wert ist und einem Offset b entspricht, das zwischen zwei aufeinanderfolgenden Messung berechnet und durch die Verstärkung $G_e$ der Vorrichtung im Augenblick der Eichung dividiert wird ($B = b/G_e$).

6. Strommessvorrichtung nach einem der Ansprüche 1 bis 5, **dadurch gekennzeichnet, dass** die Ausgangsspannung $V_S$ des operativen Verstärkers (4) auf einen vergleichenden Schaltkreis (10) angewendet wird, der das Öffnen des Schaltkreises bewirken kann, in dem der Strom I fließt, wenn die Spannung $V_S$ einen Grenzwert $V_L$ überschreitet.

**Claims**

1. Device (1) for measuring current in an electrical circuit (C), device in which the measurement of a current 1 is carried out across a component (2) incorporated in series in the circuit, the measurement being carried out by implementing at least one operational amplifier (4) supplied by the current flowing through the component (2), the device being **characterized in that** it comprises a computer (5) coupled to a sensor (6) for measuring the temperature of the component (2) and to a variable resistor $R_v$ incorporated in the gain adjustment circuit of the operational amplifier (4), the computer (5) being provided with an algorithm driving the value of the variable resistor $R_v$ as a function of the internal resistance $R_{ON}$ of the component (2) which itself varies as a function of the temperature according to a law or a table incorporated in the computer (5), such that, if we denote by $V_s$ the output voltage of the operational amplifier (4) which is the image of the current 1 to be measured, the variable resistor $R_v$ is corrected so that the ratio $K = V_S/I$ is constant over the entire operating temperature range of the circuit.

2. Current measuring device according to claim 1, **characterized in that** the variable resistor $R_v$ is arranged in series with a first fixed resistor R1 of the assembly of the operational amplifier (4), the feedback resistor being denoted R2, the resistance of the component being denoted $R_{ON}$, K being the constant ratio $V_s/I$, the variable resistor $R_v$ will have a value:

$$R_v = (R1 + R2 - K.R1/ R_{ON}) \bullet [R_{ON}/(K- R_{ON})]$$

3. Current measuring device according to claim 2, **characterized in that** the analog output voltage $V_s$ of the operational amplifier (4) is converted into a digital value $V_\mu$ by the computer (5) to which the voltage $V_s$ is applied by the intermediary of a divider bridge formed by two resistors R3 and R4, the digital voltage $V_\mu$ converted by the computer thus being equal to:

$$V_\mu = V_s . [R4/(R4+R3)] . [2^n/Vr_{ef}]$$

$V_{ref}$ being the reference voltage of the analog/digital converter (9) incorporated in the computer (5) and n being the resolution of this converter (9).

4. Current measuring device according to claim 3, **characterized in that** the value of the variable resistor $R_v$ is corrected by a slope correction coefficient P, which coefficient is calculated during a calibration prior to the use of the device and which is applied to the ratio K (corrected ratio K' = P.K), the coefficient P being calculated by measuring the ratio between the expected and actual deviations between two successive measurements of the voltage $V_\mu$, which is the digital image of the intensity measured as seen by the calculator (5).

5. Current measuring device according to claim 4, **characterized in that** the measured value is corrected by an offset value B which is calculated during a preliminary calibration and which is multiplied during the measurement by the gain $G_m$ of the device at the time of measurement, namely $Y_{\mu cor} = V_\mu - B.G_m$, expression in which $V_{\mu cor}$ is the value of the measurement as corrected and used for the control of $R_v$, $Y_\mu$ is the value of the digital image of the intensity at the output of the analog/digital converter (9), and $G_m$ the gain of the device at the time of the measurement considered ($G_m = 1 + R2/(RI+R_v)$), the offset value B being a value corrected during calibration and corresponding to an offset b calculated between two successive measurements and divided by the gain $G_e$ of the device at the time of calibration ($B = b/G_e$)

6. Current measuring device according to one of claims 1 to 5, **characterized in that** the output voltage $V_s$ of the operational amplifier (4) is applied to a comparator circuit (10) capable of causing the opening of the circuit in which the current 1 flows when the voltage $V_s$ exceeds a threshold $V_L$.

Fig. 1

Fig. 2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2656932
- EP 0744033 A

- US 2011089931 A